# EUROPÄISCHE PATENTSCHRIFT

(11) **EP 1 388 206 B1**
(45) Veröffentlichungstag und Bekanntmachung des Hinweises auf die Patenterteilung: **29.12.2004**
(21) Anmeldenummer: 02732677.6
(22) Anmeldetag: 25.04.2002
(51) Int. Cl.: H03H 9/54, H03H 7/09

(54) **FILTERANORDNUNG FUER SYMMETRISCHE UND UNSYMMETRISCHE LEITUNGSSYSTEME**
FILTER ARRANGEMENT FOR SYMMETRICAL AND ASYMMETRICAL LINE SYSTEMS
DISPOSITIF FILTRE DESTINE A DES SYSTEMES DE LIGNES SYMETRIQUES ET ASYMETRIQUES

(30) Priorität: 14.05.2001 DE 10123369
(43) Veröffentlichungstag der Anmeldung: 11.02.2004
(73) Patentinhaber: Infineon Technologies AG, 81669 München (DE)
(72) Erfinder: HEUERMANN, Holger, 83629 Weyarn (DE); RUEDIGER, Jens, 40547 Düsseldorf (DE)
(74) Vertreter: Zimmermann, Tankred Klaus
(86) Internationale Anmeldenummer: PCT/EP2002/004617
(87) Internationale Veröffentlichungsnummer: WO 2002/093741

(56) Entgegenhaltungen:
- US-A- 1 848 221
- US-A- 5 666 093
- PATENT ABSTRACTS OF JAPAN vol. 010, no. 158 (E-409), 6. Juni 1986 (1986-06-06) & JP 61 013706 A (MATSUSHITA DENKI SANGYO KK), 22. Januar 1986 (1986-01-22)
- ORLOV A T ET AL: "Use of active networks to widen the spectrum of application of piezoelectric filters" FREQUENCY CONTROL SYMPOSIUM, 1994. 48TH., PROCEEDINGS OF THE 1994 IEEE INTERNATIONAL BOSTON, MA, USA 1-3 JUNE 1994, NEW YORK, NY, USA,IEEE, 1. Juni 1994 (1994-06-01), Seiten 411-414, XP010137841 ISBN: 0-7803-1945-1

## Beschreibung

Die vorliegende Erfindung bezieht sich auf eine Filteranordnung und insbesondere auf eine Resonatorbandpaßfilteranordnung für symmetrische und unsymmetrische Leitungssysteme.

Bandpassfilter werden in nahezu jeder Mikrowellenapplikation benötigt. Insbesondere schmalbandige Sende/Empfangsschaltungen (sogenannte Transceiver-Schaltungen), wie sie in Mobilfunksystemen eingesetzt werden, benötigen Bandpassfilter, um alle Störsignale, die sich außerhalb des genutzten Frequenzbandes befinden, zu unterdrücken. Somit können große Störsignale die Empfänger nicht in die Begrenzung treiben und kleine Störsignale verschlechtern das Grundrauschen nicht. Ferner finden Bandpassfilter in sogenannten Multibandsystemen Anwendung, um über Frequenzweichen, sogenannte Diplexer, die einzelnen Bänder zu selektieren.

Gute Bandpassfilter zeichnen sich dadurch aus, dass sie im Durchlassband sehr wenig elektrische Verluste aufweisen und im Sperr- bzw. Stoppband eine möglichst große Isolation haben.

Häufig werden in Bandpassfiltern Resonatoren eingesetzt. Von einem Serienresonator spricht man, wenn dieses Zweiklemmenelement, sofern es in Serie geschaltet ist, bei der Resonanzfrequenz ein sehr gutes Durchlassverhalten aufweist. Für andere Frequenzen weist dieses Element ein Sperrverhalten auf. Von einem Parallelresonator spricht man, wenn dieses Zweiklemmenelement, sofern es zwischen dem Signalweg und einem Bezugspotential, wie z. B. Masse, geschaltet ist, bei der Resonanzfrequenz ein sehr gutes Durchlassverhalten aufweist. Für andere Frequenzen weist dieses Element ein Sperrverhalten auf.

Ein Symmetrierglied (Balun) wird dort eingesetzt, wo ein Übergang von einem unsymmetrischen zu einem symmetrischen Leitungssystem, z. B. einem Mikrowellenleitungssystem, oder umgekehrt erforderlich ist. In modernen Handsetgeräten haben die in Halbleitern integrierten Kleinsignal-Sende/Empfangsschaltungen (Kleinsignal-Transceiver) nur symmetrische Einund Ausgänge. Hingegen sind Leistungsverstärker und Antennen in unsymmetrischer Technik ausgeführt. Daher sind in solchen Handsetgeräten für jedes Frequenzband zwei Netzwerke erforderlich, um verlustarme Übergänge zwischen dem symmetrischen Leitungssystem und dem unsymmetrischen Leitungssystem zu realisieren. Im Mobilfunkbereich sind bisher die unsymmetrischen Schaltungen, wie z. B. Diplexer, die klassischen und alleinig eingesetzten Schaltungen. Ferner sind eine Großzahl der in der Praxis genutzten Leitungssysteme, wie beispielsweise Koaxial-, Mikrostreifen- und Streifenleitungen, unsymmetrische Systeme.

Zur Realisierung von Bandpassfiltern existieren eine große Anzahl von Realisierungsmöglichkeiten.

Seit vielen Jahrzehnten sind Filter mit konzentrierten induktiven Bauelementen und Kapazitäten oder mit Leitungsstrukturen bekannt. In Frequenzweichen (Diplexern) werden in der Regel reine Leitungsstrukturen verwendet.

Für schmalbandige Filteranwendungen werden seit Jahren Oberflächenwellenfilter, die bekannten SAW-Filter (SAW = Surface Acoustic Wave = akustische Oberflächenwelle) verwendet, in denen nicht-gekoppelte Resonatoren zum Einsatz kommen. Solche nicht-gekoppelten Resonatoren sind beispielsweise in der sogenannten Ladder-Typ-Struktur angeordnet.

Für schmalbandige Bandpassfilter haben sich Realisierungen mit gekoppelten Resonatoren erst seit einigen Jahren für Schaltungen im Mobilfunkbereich etabliert. Diese Filterrealisierungen zeichnen sich insbesondere durch ihre sehr steilen Filterflanken aus. Diese Technologie findet ihren Einsatz bei großen Resonatoren, z. B. aus zylinderförmigen Keramiken mit geringen Verlusten und großer Dielektrizitätskonstante, und bei Filtern für große Leistungen, wie sie beispielsweise in Basisstationen verwendet werden.

Die geraden beschriebenen, bekannten Filterrealisierungen sind dahingehend nachteilhaft, dass diese ausschließlich für symmetrische Leitungssysteme oder ausschließlich für unsymmetrische Leitungssysteme verfügbar sind. Die Filterrealisierungen haben somit entweder ein symmetrisches Eingangstor und ein symmetrisches Ausgangstor oder ein unsymmetrisches Eingangstor und ein unsymmetrisches Ausgangstor. Mischkonstruktionen aus gekoppelten Resonatoren und konzentrierten Bauelementen, wie beispielsweise induktiven Bauelementen, sind nicht bekannt.

Die Einsparung des Symmetriergliedes, des Baluns, ist im Stand der Technik nur im Zusammenhang mit Oberflächenwellenfiltern (SAW-Filtern) bekannt. Die relativ aufwendigen und teuren SAW-Filter bieten eine Möglichkeit der Balancierung des unsymmetrischen Signals, indem eine physikalisch sehr kurze 180°-Leitung im akustischen Bereich eingefügt wird. SAW-Filter bieten eine sehr steile Filtercharakteristik bei mittleren Durchgangsverlusten von etwa 2 bis 3 dB und haben sich als Empfangsfilter vor den Vorverstärkern der Sende/Empfangsschaltungen etabliert. Auf der Sendeseite von Sende/Empfangsschaltungen werden überwiegend in Keramik realisierte Symmetrierglieder (Baluns) eingesetzt.

Der Nachteil der oben beschriebenen, im Stand der Technik bekannten Realisierungen von Bandpassfiltern besteht zum einen darin, dass Bandpassfilter mit diskreten induktiven Bauelementen und Kondensatoren für kommerzielle Mikrowellenprodukte, die in großen Mengen gefertigt werden, uninteressant sind, da die Anzahl der erforderlichen Bauelemente sehr groß ist und somit die erforderliche Fläche sehr groß ist. Ferner sind die Verluste im Durchlassbereich unzulässig hoch. Demgegenüber bieten gekoppelte Resonatorfilter bessere Selektionseigenschaften bei geringeren Verlusten als die "verschalteten" Resonatorfilter, wie beispielsweise die Ladder-Typ-Strukturen. Die kommerziell sehr erfolgreichen SAW-Filter basieren aufgrund ihrer nicht-gekoppelten Resonatortechnologie auf einer veralteten Topologie.

Für die Realisierung von Frequenzweichen, Diplexern, haben die SAW-Filter eine zu große Durchlassdämpfung, welche bei Diplexern bei etwa 0,7 dB liegt. Ferner sind die SAW-Filter nicht großsignalstabil, so dass das von einem Leistungsverstärker ausgegebene Signal das Filter zerstören würde. Hinter dem Ausgang der Sende/Empfangsschaltung ist ein SAW-Filter zu teuer.

Ein Symmetrierglied hat gegenüber einem SAW-Filter zu geringe Selektionseigenschaften, so dass auch dessen Einsatz nicht vorteilhaft ist.

Hinsichtlich der im Stand der Technik bekannten Realisierungen für Bandpassfilter ist somit zusammenfassend festzustellen, dass diese in der Realisierung zu aufwendig sind, zu hohe Verlust im Durchlassbereich aufweisen und/oder eine zu geringe Selektionseigenschaft haben.

Die US-A-1,848,221 beschreibt eine Filterschaltung, die aus einer Serieninduktivität aus einer Serienspule und aus zwei Parallelzweigen, die jeweils aus einer Serienschaltung aus einer Induktivität und einem Kondensator bestehen, beschreibt. Das Filter ist zwischen eine Eingangsschaltung und eine Ausgangsschaltung geschaltet, wobei die Spulen in den Parallelzweigen miteinander verkoppelt sind.

Die JP 61-013706A beschreibt ein Bandpaßfilter, welches einen LC-Serienresonanzkreis aufweist, der in Reihe mit einem anderen LC-Serienresonanzkreis geschaltet ist. Ein LC-Parallelresonanzkreis ist zwischen die Verbindung der zwei.LC-Serienresonanzkreise und Masse geschaltet. Die in den LC-Serienresonanzkreisen verwendeten Induktivitäten sind miteinander gekoppelt.

In dem Artikel von Orlov A. T., "Use of Active Networks to widen the spectrum of application of piezoelectric filters", in "Frequency Control Symposium, 1994, Proceedings of the 1994 IEEE International Boston, June 1, 1994, pages 411 to 414" wird der Entwurf von aktiven BAW-piezoelektrischen Filtern beschrieben, deren Eigenschaften mit induktivitatsfreien passiven piezoelektrischen Filtern nicht erreichbar sind.

Ausgehend von diesem Stand der Technik liegt der vorliegenden Erfindung die Aufgabe zugrunde, eine verbesserte Filteranordnung zu schaffen, welche eine geringe Durchlassdämpfung aufweisen, großsignalstabil sind und gute Selektionseigenschaften aufweisen.

Diese Aufgabe wird durch eine Filteranordnung gemäß Anspruch 1 sowie durch eine Filteranordnung gemäß Anspruch 12 gelöst.

Die vorliegende Erfindung schafft eine neue Klasse von Filtern, insbesondere Bandpassfiltern, die sich für symmetrische, unsymmetrische und sogar gemischt-symmetrische Ein- und Ausgangsleitungen eignen.

Bei einem bevorzugten Ausführungsbeispiel wird ein neuer Ansatz verfolgt, gemäß dem konzentrierte Bauelemente mit ungekoppelten und gekoppelten Leitungen verwendet werden, wodurch sich sehr selektive Bandpassfilter ergeben, die sich mit einer sehr geringen Anzahl von Bauelementen auf kleinstem Raum realisieren lassen.

Neben diesen praktisch sehr großen Vorteilen für reine Bandpassfilterfunktionen bietet die vorliegende Erfindung ferner Topologien, mit denen Filter mit einem unsymmetrischen Eingangstor und einem symmetrischen Ausgangstor bzw. einem symmetrischen Eingangstor und einem unsymmetrischen Ausgangstor realisiert werden können. Diese Filter haben konzeptbedingt nicht mehr Verluste als Filter mit gleichen Ein- und Ausgangstoren. Mit diesen Filtern ist es möglich, in vielen Anwendungen die Verluste und Kosten, die durch die ansonsten erforderlichen Symmetrierglieder (Baluns) auftreten, einzusparen.

Bei einem weiteren bevorzugten Ausführungsbeispiel sind die erfindungsgemäßen Filter aus mindestens zwei verkoppelten Leitungen oder Resonatoren und einem Kondensator oder einer Spule aufgebaut. Gemäß der vorliegenden Erfindung werden Topologien für gekoppelte Serien- und Parallelresonatoren geschaffen.

Bei einem anderen bevorzugten Ausführungsbeispiel der vorliegenden Erfindung ist eine Schaltungstopologie für ein Bandpassfilter vorgesehen, das Resonatoren, von denen zumindest zwei miteinander gekoppelt sind, und eine oder mehrere induktive Bauelemente aufweist. Gemäß einem weiteren Ausführungsbeispiel wird eine Schaltungstopologie für ein Bandpassfilter geschaffen, das aus Hochfrequenzleitungspaaren und aus einem oder mehreren induktiven Bauelementen besteht, wobei die Hochfrequenzleitungspaare niederohmige und hochohmige Leitungen aufweisen, wobei zumindest zwei hochohmige Leitungen über eine Teillänge elektromagnetisch verkoppelt sind.

Ein erstes Ausführungsbeispiel betrifft ein Bandpassfilter mit einem Eingang und einem Ausgang aus je einem symmetrischen Mikrowellentor. Hinter dem Eingangstor sind n (n = 1, 2, ...) C-Glieder vorgesehen. Jedes der C-Glieder umfasst einen Resonator oder ein Hochfrequenzleitungspaar, das jeweils zwei niederohmige und eine hochohmige Leitung mit einer elektrischen Länge von kleiner λ/4 aufweist, wobei die niederohmigen Leitungen mit den symmetrischen Toren bzw. Leitungen verbunden sind. Je symmetrischem Leitungszweig ist ein serielles induktives Bauelement vorgesehen. Vor dem Ausgangstor ist ein weiterer Resonator oder ein weiteres Hochfrequenzleitungspaar vorgesehen, das jeweils zwei niederohmige und eine hochohmige Leitung mit einer elektrischen Länge von kleiner λ/4 aufweist, wobei die niederohmigen Leitungen mit den symmetrischen Leitungen verbunden sind.

Ein zweites Ausführungsbeispiel betrifft ein Bandpassfilter mit einem Eingang und einem Ausgang aus einem unsymmetrischen und einem symmetrischen Mikrowellentor. Hinter dem Eingangstor befinden sich n (n = 1, 2, ...) C-Glieder. Die C-Glieder umfassen einen Resonator oder ein Hochfrequenzleitungspaar, das jeweils zwei niederohmige und eine hochohmige Leitung mit einer elektrischen Länge von kleiner λ/4 aufweist, wobei das Hochfrequenzleitungspaar jeweils mit den niederohmigen Leitungen mit den symmetrischen Leitungen verschaltet sind. Ferner ist je symmetrischem Leitungszweig ein serielles induktives Bauelement vorgesehen. Vor dem Ausgangstor befindet sich ein weiterer Resonator oder ein weiteres Hochfrequenzleitungspaar, das jeweils zwei niederohmige und eine hochohmige Leitung mit einer elektrischen Länge von kleiner λ/4 aufweist, wobei bei dem weiteren Hochfrequenzleitungspaar jeweils die niederohmigen Leitungen mit den Leitungen verbunden sind.

Ein drittes Ausführungsbeispiel betrifft ein Bandpassfilter mit einem Eingang und einem Ausgang aus je einem symmetrischen Mikrowellentor. Hinter dem Eingangstor befinden sich n (n = 1, 2, ...) gespiegelte C-Glieder. Die C-Glieder umfassen je zwei Serienelemente in Form zweier Resonatoren oder Hochfrequenzleitungspaare, die jeweils eine gekoppelte niederohmige und eine hochohmige Leitung mit einer elektrischen Länge von kleiner λ/4 aufweisen. Ferner ist ein induktives Bauelement vorgesehen, das zwischen die symmetrischen Leitungszweige geschaltet ist. Vor dem Ausgangstor befinden sich zwei weitere Serienelemente in Form zweier Resonatoren oder in der Form von Hochfrequenzleitungspaaren, die jeweils eine gekoppelte niederohmige und eine hochohmige Leitung mit einer elektrischen Länge von kleiner λ/4 aufweisen.

Ein viertes Ausführungsbeispiel betrifft ein Bandpassfilter mit einem Eingang und einem Ausgang aus einem unsymmetrischen und einem symmetrischen Mikrowellentor. Hinter dem Eingangstor befinden sich n (n = 1, 2, ...) gespiegelte C-Glieder. Die C-Glieder umfassen je zwei Serienelemente in Form zweier Resonatoren oder in Form von Hochfrequenzleitungspaaren, die jeweils eine gekoppelte niederohmige und eine hochohmige Leitung mit einer elektrischen Länge von kleiner λ/4 aufweisen. Diejenigen Serienelemente, die nicht am symmetrischen Tor angeschlossen sind, sind gegen ein Bezugspotential, wie z. B. Masse, geschaltet. Ein induktives Bauelement ist zwischen die symmetrischen Leitungszweige geschaltet. Vor dem Ausgangstor befinden sich zwei weitere Serienelemente in Form zweier Resonatoren oder in Form von Hochfrequenzleitungspaaren, die jeweils eine gekoppelte niederohmige und eine hochohmige Leitungmit einer elektrischen Länge von kleiner λ/4 aufweisen.

Ein Vorteil der vorliegenden Erfindung besteht darin, dass aufgrund des erfindungsgemäßen Bandpassfilters, das beispielsweise als LDC-Resonator-Bandpassfilter realisiert ist (LDC = Lumped Distributed Coupled = konzentriert verteilt gekoppelt) ein hoch integrierter Diplexer (Frequenzweiche) realisierbar ist, der den erforderlichen Eigenschaften hinsichtlich Durchgangsverlust und Selektionseigenschaften einschließlich einer Leistungsverträglichkeit von 36 dBm im Handsetgerät gerecht wird.

Ein weiterer Vorteil der vorliegenden Erfindung besteht darin, dass diese es ermöglicht, ein Bandpassfilter zu synthetisieren, das neben den herausstehenden Selektionseigenschaften eine Modenkonvertierung zwischen einem unsymmetrischen und einem symmetrischen Leitungsmode durchführt. Realisiert man dieses Filter mit gekoppelten Leitungen in einer Keramik, so erhält man einerseits aufgrund der geringen Anzahl von Leitungselementen als auch andererseits aufgrund der Tatsache, dass die Leitungen verkoppelt sind und somit sehr eng zusammen liegen, eine sehr große Packungsdichte.

Gemäß einem weiteren Vorteil der vorliegenden Erfindung ist es möglich, Resonatorfilter mit hoher Güte, wie beispielsweise SAW-Filter, mittels der erfindungsgemäßen Topologie deutlich zu verbessern, so dass bei gleicher Sperrisolation die Anzahl der erforderlichen Resonatoren geringer ist und somit neben einer Absenkung der Durchlassverluste gleichzeitig die Kosten für die Realisierung gesenkt werden. Ist eine Modenkonvertierung erforderlich, so benötigt man gemäß der vorliegenden Erfindung keine 180°-Leitung mehr. Die vorliegende Erfindung eröffnet daher die Möglichkeit, mit anderen Resonatoren hoher Güte, wie z. B. unter Verwendung von Quarzresonatoren und Bulk-Acoustic-Wave-Resonatoren (Bulk-Acoustic-Wave = akustische Volumenwelle), Bandpassfilter mit Modenkonvertierungseigenschaften zu realisieren.

Da gemäß der vorliegenden Erfindung keine zusätzlichen Leitungen erforderlich sind und die Phasengenauigkeit eines Resonators besser ist als die einer kurzen akustischen Leitung, ergeben sich bei Filtern gemäß der vorliegenden Erfindung prinzipbedingt geringere Durchlassverluste.

Gemäß einem weiteren Vorteil der vorliegenden Erfindung wird eine Topologie für ein Filter mit symmetrischen Ein- und Ausgängen geschaffen.

Bevorzugte Weiterbildungen der vorliegenden Anmeldung sind in den Unteransprüchen definiert.

Nachfolgend werden anhand der beiliegenden Zeichnungen bevorzugte Ausführungsbeispiele der vorliegenden Erfindung näher erläutert. Es zeigen:
Fig. 1 ein LDC-Resonator-Bandpassfilter mit Parallelresonatoren mit unsymmetrischem Eingangs- und Ausgangstor in Leitungstechnik;
Fig. 2 ein LDC-Resonator-Bandpassfilter mit Parallelresonatoren mit symmetrischem Eingangs- und Ausgangstor in Leitungstechnik;
Fig. 3 ein LDC-Resonator-Bandpassfilter mit Parallelresonatoren mit unsymmetrischem Eingangstor und symmetrischem Ausgangstor in Leitungstechnik;
Fig. 4 ein Resonatorbandpassfilter mit unsymmetrischem Eingangstor und symmetrischem Ausgangstor mit gekoppelten Resonatoren;
Fig. 5 ein Resonatorbandpassfilter mit Serienresonatoren mit unsymmetrischem Eingangs- und Ausgangstor in Leitungstechnik;
Fig. 6 ein Resonatorbandpassfilter mit Serienresonatoren mit symmetrischem Eingangs- und Ausgangstor in Leitungstechnik;
Fig. 7 ein Resonatorbandpassfilter mit unsymmetrischem Eingangstor und symmetrischem Ausgangstor in Leitungstechnik;
Fig. 8 eine schematische Darstellung der in den Schaltungen gemäß der vorliegenden Erfindung vorzugsweise verwendeten gekoppelten Hochfrequenzleitungen;
Fig. 9A den Verlauf von Reflexionsfaktor und Durchlassdämpfung für ein Bandpassfilter mit einer Impedanz von 50Ω an beiden Toren; und
Fig. 9B den Verlauf von Reflexionsfaktor und Durchlassdämpfung für ein Bandpassfilter mit einer Impedanz von 50Ω an einem ersten Tor und von 25Ω an einem zweiten Tor.

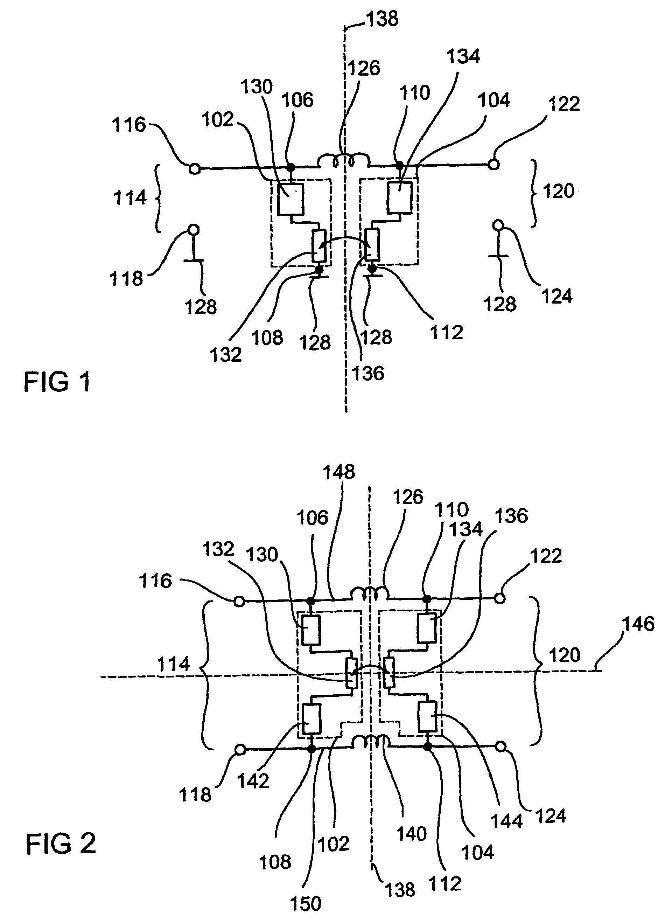

Fig. 1 zeigt ein Resonatorbandpassfilter mit unsymmetrischem Ein- und Ausgang. Das Resonatorbandpassfilter umfasst eine erste Resonatoreinrichtung 102 und eine zweite Resonatoreinrichtung 104. Die erste Resonatoreinrichtung 102 ist zwischen einen ersten Knoten 106 und einen zweiten Knoten 108 geschaltet. Die zweite Resonatoreinrichtung 104 ist zwischen einen dritten Knoten 110 und einen vierten Knoten 112 geschaltet. Das Resonatorbandpassfilter umfasst ferner ein Eingangstor 114, das einen ersten Eingangstorknoten 116 und einen zweiten Eingangstorknoten 118 umfasst. Ferner ist ein Ausgangstor 120 vorgesehen, das einen ersten Ausgangstorknoten 122 sowie einen zweiten Ausgangstorknoten 124 umfasst. Ferner umfasst das Resonatorbandpassfilter ein induktives Bauelement 126, z. B. in der Form einer Spule, das zwischen den ersten Knoten 106 und den dritten Knoten 110 geschaltet ist.

Bei dem in Fig. 1 gezeigten Filter ist der erste Eingangstorknoten 116 mit dem ersten Knoten 106 und der erste Ausgangstorknoten 122 mit dem dritten Knoten 110 verbunden. Der zweite Knoten 108, der vierte Knoten 112, der zweite Eingangstorknoten 118 sowie der zweite Ausgangstorknoten 124 sind mit einem Bezugspotential 128, z. B. Masse, verbunden.

Das in Fig. 1 dargestellte Filter illustriert den topologischen Aufbau für den Fall, dass der Eingang 114 und der Ausgang 120 jeweils durch ein unsymmetrisches Mikrowellentor gebildet ist. Eine Großzahl der in der Praxis benutzten Leitungssysteme, wie z. B. Koaxialleitungen, Mikrostreifenleitungen und Streifenleitungen, sind unsymmetrische Systeme. In Fig. 1 ist eine einfache Realisierung unter Verwendung gekoppelter Hochfrequenzleitungen dargestellt. Die erste Resonatoreinrichtung 102 umfasst eine erste Hochfrequenzleitung 130 sowie eine zweite Hochfrequenzleitung 132, die seriell zwischen den ersten Knoten 106 und den zweiten Knoten 108 geschaltet sind. Die zweite Resonatoreinrichtung umfasst eine dritte Hochfrequenzleitung 134 sowie eine vierte Hochfrequenzleitung 136, die seriell zwischen den dritten Knoten 110 und den vierten Knoten 112 geschaltet sind.

Wie aus Fig. 1 zu erkennen ist, ist das aus den Hochfrequenzleitungen 130 und 132 bestehende Leitungspaar parallel zu dem Eingangstor 114 angeordnet, ist also zwischen den Eingangstorknoten 116 des Eingangstors 114 bzw. den ersten Knoten 106 und Masse 128 geschaltet, wobei die Hochfrequenzleitungen jeweils eine elektrische Länge aufweisen, die kleiner als λ/4 ist, wobei λ die Wellenlänge der auf den Leitungen laufenden Wellen darstellt. Die erste Hochfrequenzleitung 130 hat einen optimierten, niederohmigen Wellenwiderstand Z₁₃₀ und ist mit keiner anderen Leitung verkoppelt. Die erste Hochfrequenzleitung 130 hat eine kapazitive Wirkung. Anstelle der in Fig. 1 dargestellten Realisierung der Hochfrequenzleitung 130 kann dieselbe auch als leerlaufende, kurze Stichleitung ausgeführt sein, deren nicht-leerlaufendes Ende mit dem Knoten 106 verbunden ist, wobei in diesem Fall auch gleichzeitig der Eingang der zweiten Hochfrequenzleitung 132 mit dem Knoten 106 verbunden ist.

Die zweite Hochfrequenzleitung 132 hat einen optimierten hochohmigen Wellenwiderstand Z₁₃₂, der sich in der Regel vom Wellenwiderstand Z₁₃₀ der ersten Hochfrequenzleitung unterscheidet. Die zweite Hochfrequenzleitung 132 ist elektromagnetisch mit der vierten Hochfrequenzleitung 136 verkoppelt, wie dies durch den Pfeil in Fig. 1 dargestellt ist.

Die dritte Hochfrequenzleitung 134 und die vierte Hochfrequenzleitung 136 sind parallel zu dem Ausgangstor 120 angeordnet, sind also zwischen dem Ausgangstorknoten 122 des Ausgangstors 120 bzw. dem dritten Knoten 110 und Masse 128 angeordnet. Zwischen den beiden Toren 114 und 120 ist zwischen dem Knoten 106 und 110 das induktive Bauelement 126 angeordnet. Das induktive Bauelement kann als konzentriertes Bauelement, z. B. als SMD-Bauelement, SMD = Surface Mounted Device = oberflächenbefestigbares Bauelement), oder als Leitungsbauelement realisiert sein.

Unter der Annahme, dass die beiden Mikrowellentore 114 und 120 die gleiche Referenzimpedanz aufweisen, muss die dritte Hochfrequenzleitung 134 hinsichtlich Wellenwiderstand und elektrischer Länge der ersten Hochfrequenzleitung 130 entsprechen. Gleiches gilt für die Hochfrequenzleitungen 132 und 136. In diesem Fall muss die Filterschaltung bezüglich der Mittelachse 138 spiegelsymmetrisch sein. Bei beliebigen Referenzimpedanzen an den beiden Toren 114 und 120 kann das Filter zur Impedanztransformation verwendet werden, wobei in diesem Fall die Symmetrieeigenschaften nicht mehr gegeben sind. Unter Verwendung des Filters kann beispielsweise ein hochintegrierter Diplexer realisiert werden.

Um unter Verwendung des Filters aus Fig. 1 bessere Selektionseigenschaften zu erzielen, sind alternierend zusätzliche serielle induktive Bauelemente und Leitungspaare, die gegen das Bezugspotential verschaltet sind, einzufügen. Es müssen jedoch nicht sämtliche hochohmigen Leitungen der Leitungspaare miteinander koppeln. Je größer der Anteil der verkoppelten Leitung ist, desto besser sind jedoch die Selektionseigenschaften.

Anstelle der kapazitiv wirkenden Hochfrequenzleitungen 130 und 134 können auch konzentrierte Kondensatoren eingesetzt werden, die zwischen den Knoten 106 bzw. 110 und das Bezugspotential 128 geschaltet sind, wobei in diesem Fall die zweiten Hochfrequenzleitungen 132 und 136 direkt mit dem ersten Knoten 106 bzw. 110 verbunden sind.

Anstelle der in Fig. 1 gezeigten Leitungspaare können auch alle anderen Resonatoren eingesetzt werden, sofern sich diese miteinander verkoppeln lassen und im Durchlassbereich eine Parallelresonanz, ein Sperrverhalten, aufweisen. Beispiele für solche Resonatoren sind Oberflächenwellenresonatoren (SAW-Resonatoren), Quarzresonatoren, dielektrische Resonatoren, akustische Volumenwellen-Resonatoren und ähnliche.

In Fig. 2 ist ein Resonatorbandpassfilter gemäß einem Ausführungsbeispiel der vorliegenden Erfindung dargestellt, das einen symmetrischen Eingang/Ausgang aufweist. In Fig. 2 sind Komponenten, die anhand der Fig. 1 beschrieben wurden, mit den gleichen Bezugszeichen versehen.

Bei dem in Fig. 2 dargestellten Ausführungsbeispiel ist, anders als in Fig. 1, der zweite Eingangstorknoten 118, der zweite Knoten 108, der vierte Knoten 112 und der zweite Ausgangstorknoten 124 nicht mit einem Bezugspotential verbunden. Vielmehr ist der erste Eingangstorknoten 118 mit dem zweiten Knoten 108 verbunden und der zweite Ausgangstorknoten 124 ist mit dem vierten Knoten 112 verbunden. Zusätzlich ist zwischen dem zweiten Knoten 108 und dem vierten Knoten 112 ein weiteres induktives Bauelement 140 angeordnet. Ferner umfasst die erste Resonatoreinrichtung 102 zusätzlich eine fünfte Hochfrequenzleitung 142, wobei die Hochfrequenzleitungen 130, 132 und 142 der ersten Resonatoreinrichtung 102 zwischen den ersten Knoten 106 und den zweiten Knoten 108 geschaltet sind. Ebenso umfasst die zweite Resonatoreinrichtung 104 eine weitere, sechste Hochfrequenzleitung 144. Die Hochfrequenzleitungen 134, 136 und 144 der zweiten Resonatoreinrichtung 104 sind seriell zwischen den dritten Knoten 110 und den vierten Knoten 112 geschaltet.

In Fig. 2 ist ein Bandpassfilter dargestellt, bei dem das Eingangstor 114 und das Ausgangstor 120 jeweils ein symmetrisches Mikrowellentor sind. Die Filtertopologie ist in diesem Fall derart, dass hinter dem Eingangstor 114 zwei in Serie geschaltete Leitungspaare vorgesehen sind, die aus der kapazitiven Hochfrequenzleitung 130, der doppelten induktiven Leitung 132 und der weiteren kapazitiven Leitung 142 besteht, wobei die zweite Hochfrequenzleitung 132 bei diesem Ausführungsbeispiel eine Länge von etwa λ/2 hat. Im weiteren weist die dargestellte Topologie die zwei seriellen induktiven Bauelemente 126 und 140 auf sowie das weitere doppelte Leitungspaar bestehend aus den Hochfrequenzleitungen 134, 136 und 144, die ähnlich den Leitungen 130, 132 und 142 durch zwei kapazitive Leitungen 134 und 144 sowie eine induktive Leitung 136 mit einer Länge von etwa λ/2 gebildet sind. Die induktiven Leitungen 132 und 136 sind elektromagnetisch verkoppelt, wie durch den Pfeil in Fig. 2 zu erkennen ist. Die erste Hochfrequenzleitung 130, die fünfte Hochfrequenzleitung 142, die dritte Hochfrequenzleitung 134 und die sechste Hochfrequenzleitung 144 sind niederohmige Leitungen, wohingegen die zweite Hochfrequenzleitung 132 und die vierte Hochfrequenzleitung 136 hochohmige Leitungen sind.

Das besondere an der in Fig. 2 dargestellten Topologie ist, dass diese bezüglich der horizontalen Mittelachse 146 spiegelsymmetrisch ist, d. h., dass z. B. die induktiven Bauelemente 126 und 140, die beispielsweise durch Spulen gebildet sind, und auch die Hochfrequenzleitungen 130 und 142 bzw. die Hochfrequenzleitungen 134 und 144 im elektrischen Verhalten einander gleichen.

Unter der Annahme, dass die beiden Tore 114 und 120 eine identische Referenzimpedanz aufweisen, ist die Filterschaltung bezüglich der vertikalen Mittelachse 138 spiegelsymmetrisch, d. h., dass die dritte Hochfrequenzleitung 134 bezüglich deren Wellenwiderstand und elektrischer Länge der erste Hochfrequenzleitung 130 entspricht. Gleiches gilt für die zweite Hochfrequenzleitung 132 und die vierte Hochfrequenzleitung 136, für die fünfte Hochfrequenzleitung 142 und die sechste Hochfrequenzleitung 144 sowie für die Spulen 126 und 140.

Bei beliebigen Torimpedanzen kann das Filter für eine Impedanztransformation herangezogen werden, wobei in diesem Fall die Symmetrieeigenschaften nicht mehr gegeben sind.

Ist es erwünscht, die Selektionseigenschaften der Filteranordnung in Fig. 2 zu verbessern, so sind alternierend zusätzliche serielle induktive Bauelemente und Leitungspaare vorzusehen, die zwischen die symmetrischen Leitungen 148 und 150, die die jeweiligen Eingangstorknoten mit den jeweiligen Ausgangstorknoten verbinden, geschaltet werden.

Es ist nicht erforderlich, dass alle hochohmigen Leitungen miteinander gekoppelt sind, doch sind die Selektionseigenschaften um so besser, je größer der Anteil der verkoppelten Leitungen ist.

Anstelle der kapazitiv wirkenden Hochfrequenzleitungen 130 und 134 sowie 142 und 144 können auch konzentrierte Kondensatoren vorgesehen sein, die zwischen die Signalleitung und Masse geschaltet sind. In diesem Fall sind die zweite Hochfrequenzleitung 132 und die vierte Hochfrequenzleitung 136 direkt mit dem ersten Knoten 106 und dem zweiten 108 bzw. dem dritten Knoten 110 und dem vierten Knoten 112 verbunden.

Statt den oben beschriebenen verkoppelten Leitungspaaren können auch alle anderen Resonatoren eingesetzt werden, sofern diese miteinander verkoppelbar sind und im Durchlassbereich eine parallele Resonanz (Sperrverhalten) aufweisen.

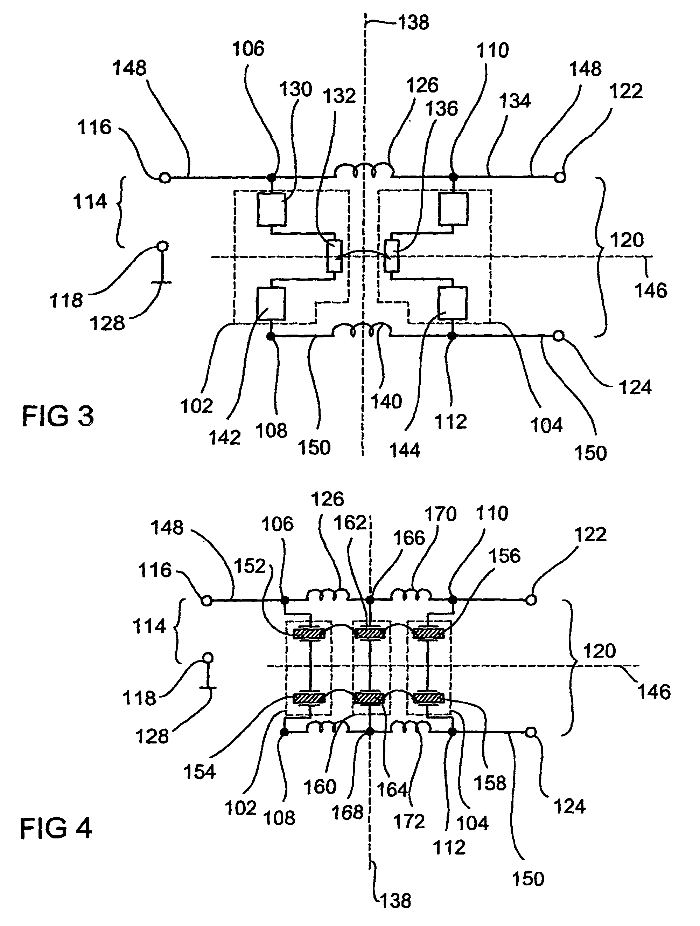

In Fig. 3 ist ein Resonatorbandpassfilter mit einem symmetrischen und einem unsymmetrischen Tor gezeigt, wobei bereits in den vorhergehenden Figuren beschriebene Elemente mit den gleichen Bezugszeichen versehen sind.

Anders als in Fig. 2 ist bei diesem Ausführungsbeispiel des Resonatorbandpassfilters der zweite Eingangstorknoten 118 des Eingangstors 114 mit einem Bezugspotential 128, z. B. Masse, verbunden. Der zweite Knoten 108 ist über die weiteren induktiven Bauelemente 140 nur mit dem zweiten Ausgangstorknoten 124 verbunden.

Das in Fig. 3 dargestellte Bandpassfilter illustriert den Fall, bei dem das Eingangstor 114 ein unsymmetrisches Tor ist und bei dem das Ausgangstor 120 ein symmetrisches Tor ist. Die Filtertopologie besteht in diesem Fall darin, dass hinter dem Eingangstor 114 zwei in Serie geschaltete Leitungspaare als erste Resonatoreinrichtung 102 sowie ein weiteres doppeltes Leitungspaar als zweite Resonatoreinrichtung 104 vorgesehen sind, die durch die zwei seriellen induktiven Bauelemente 126 und 140 verbunden sind. Die Leitungspaare der ersten Resonatoreinrichtung 102 und der zweiten Resonatoreinrichtung 104 umfassen jeweils eine erste kapazitive Hochfrequenzleitung 130 bzw. 134, eine doppelte induktive Hochfrequenzleitung 132 bzw. 136 mit einer ungefähren Länge von λ/2 und einer zusätzlichen kapazitiven Hochfrequenzleitung 142 bzw. 144.

Das besondere an dieser Topologie besteht darin, dass die Filterschaltung bezüglich der horizontalen Mittelachse 146 spiegelsymmetrisch ist. Für beliebige Torimpedanzen kann das in Fig. 3 gezeigte Filter für Impedanztransformationen herangezogen werden, wobei die Symmetrieeigenschaften bzgl. der vertikalen Achse 138 dann nicht mehr gegeben sind.

Sollen die Filtereigenschaften, z. B. die Selektionseigenschaften dieses Filters verbessert werden, so sind alternierend zusätzliche serielle induktive Bauelemente und doppelte Leitungspaare, die zwischen die symmetrischen Leitungen 148 und 150 zu schalten sind, vorzusehen. Zwar müssen nicht sämtliche hochohmigen Leitungen miteinander koppeln, jedoch verbessern sich die Selektionseigenschaften mit zunehmender Anzahl der verkoppelten Leitungen.

Statt den kapazitiven und verkoppelten Leitungen können auch sämtliche anderen Resonatoren eingesetzt werden, die miteinander verkoppelbar sind und im Durchlassbereich eine Parallelresonanz aufweisen.

Eine derartige Anordnung ist beispielhaft in Fig. 4 dargestellt, bei der die erste Resonatoreinrichtung 102 einen ersten Resonator 152 und einen zweiten Resonator 154 aufweist, die seriell zwischen den ersten Knoten 106 und den zweiten Knoten 108 geschaltet sind. Die zweite Resonatoreinrichtung 104 umfasst einen dritten Resonator 156 und einen vierten Resonator 158, die seriell zwischen den dritten Knoten 110 und den vierten Knoten 112 geschaltet sind. Zusätzlich ist bei dem in Fig. 4 dargestellten Ausführungsbeispiel eine dritte Resonatoreinrichtung 160 vorgesehen, die einen fünften Resonator 162 und einen sechsten Resonator 164 umfasst, die seriell zwischen einen fünften Knoten 166 und einen sechsten Knoten 168 geschaltet sind. Zusätzlich sind weitere induktive Bauelemente 170, 172 vorgesehen, die zwischen den dritten Knoten 110 und den fünften Knoten 166 bzw. zwischen den vierten Knoten 112 und den sechsten Knoten 168 geschaltet sind. Wie durch die Pfeile in Fig. 4 angedeutet ist, sind die einzelnen Resonatoren miteinander verkoppelt. Alternativ kann die dritte Resonatoreinrichtung 160 sowie die zusätzlichen induktiven Bauelemente 170 und 172 weggelassen werden, und in diesem Fall ergibt sich eine Anordnung ähnlich der in Fig. 3, bei der anstelle der Hochfrequenzleitungen die in Fig. 4 gezeigten Resonatoreinrichtungen mit den jeweils zwei Resonatoren, die jeweils miteinander gekoppelt sind, Verwendung findet.

Die Art der Verkopplung der Resonatoren, im allgemeinen handelt es sich hierbei um eine Energieverkopplung, hängt ganz von der Art der Realisierung des Resonators ab. Verwendet man z. B. SAW-Resonatoren, so wird die Kopplung über akustische Wellen bewirkt. Die Koppelkoeffizienten müssen einen optimierten Betrags- und Phasenwert aufweisen, dessen Wertebereich sich durch eine Vorgabe der Spulenwerte variieren lässt.

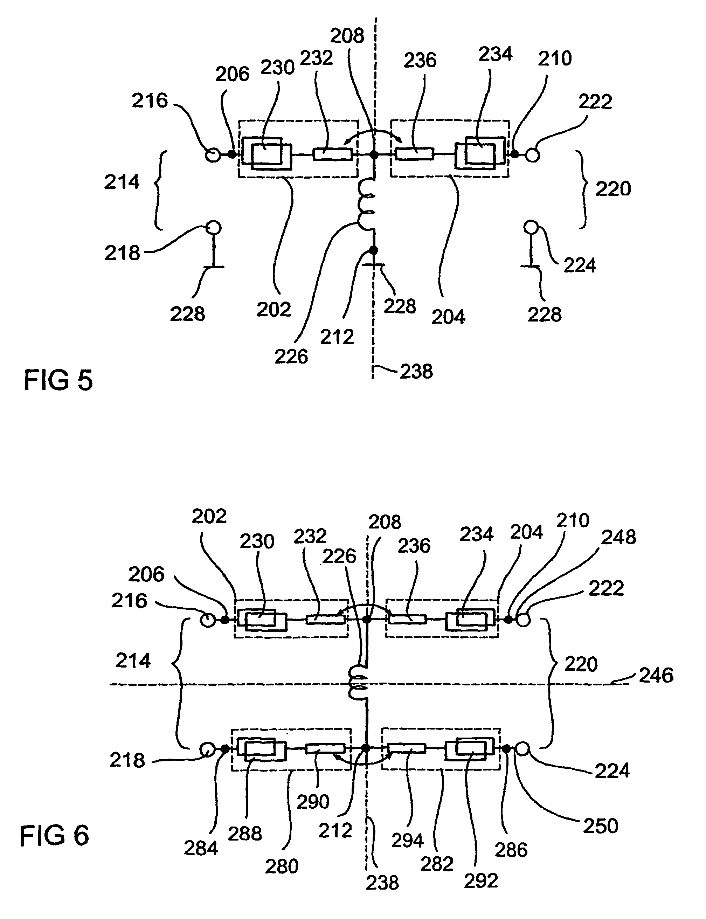

Anhand der Fig. 2 bis 4 wurden im vorhergehenden Ausführungsbeispiele für bevorzugte Resonatorbandpassfilter beschrieben, bei denen die Resonatoreinrichtungen eine Parallelresonanz im Durchlassbereich aufweisen. Nachfolgend werden anhand der Fig. 5 bis 7 Resonatorbandpassfilter beschrieben, die im Durchlassbereich eine Serienresonanz (Durchlassverhalten) aufweisen. Anhand der Fig. 5 bis 7 werden sogenannte Komplementärstrukturen zu den anhand der Fig. 1 bis 3 beschriebenen Filter erläutert.

In Fig. 5 ist ein Resonatorbandpassfilter dargestellt, das eine erste Resonatoreinrichtung 202 und eine zweite Resonatoreinrichtung 204 umfasst. Die erste Resonatoreinrichtung ist zwischen einen ersten Knoten 206 und einen zweiten Knoten 208 geschaltet. Die zweite Resonatoreinrichtung 204 ist zwischen den zweiten Knoten und einen dritten Knoten 210 geschaltet. Ferner umfasst die Filteranordnung einen vierten Knoten 212. Ein Eingangstor 214 umfasst einen ersten Eingangstorknoten 216, der mit dem ersten Knoten 206 verbunden ist, sowie einen zweiten Eingangstorknoten 218. Ein Ausgangstor 220 umfasst einen ersten Ausgangstorknoten 222, der mit dem dritten Knoten 210 verbunden ist, und einen zweiten Ausgangstorknoten 224. Zwischen dem zweiten Knoten 208 und dem vierten Knoten 212 ist ein induktives Bauelement 226, z. B. in der Form einer Spule, angeordnet. Der vierte Knoten 212 sowie der zweite Eingangstorknoten 218 und der zweite Ausgangstorknoten 224 sind mit einem Bezugspotential 228, z. B. Masse, verbunden. Die erste Resonatoreinrichtung 202 umfasst eine erste Hochfrequenzleitung 230 und eine zweite Hochfrequenzleitung 232, die seriell zwischen den ersten Knoten 206 und den zweiten Knoten 208 geschaltet sind. Die zweite Resonatoreinrichtung 204 umfasst eine dritte Hochfrequenzleitung 234 und eine vierte Hochfrequenzleitung 236, die seriell zwischen den dritten Knoten 210 und den zweiten Knoten 208 geschaltet sind.

In Fig. 5 ist der topologische Aufbau dargestellt, für den Fall, dass der Eingang 214 und der Ausgang 220 jeweils ein unsymmetrisches Mikrowellentor sind. In Fig. 5 ist eine einfache Realisierung unter Verwendung gekoppelter Hochfrequenzleitungen dargestellt. Hinter dem Eingang 214 ist die gekoppelte niederohmige Hochfrequenzleitung 230 vorgesehen, wobei die elektrischen Längen der gekoppelten Leitungen kleiner als λ/4 sind. Ferner ist eine hochohmige Leitung 132 mit einer elektrischen Länge von kleiner als λ/4 vorgesehen. Vor dem Ausgang 220 ist eine gekoppelte niederohmige Leitung 234 sowie eine hochohmige Leitung 236, deren Längen den Leitungen 230 und 232 entsprechen, vorgesehen. Zwischen den Leitungspaaren ist die Spule 226 gegen das Bezugspotential 228 geschaltet.

Die Hochfrequenzleitung 230 hat eine kapazitive Wirkung. Die zweite Hochfrequenzleitung 232 hat einen optimierten Wellenwiderstand Z₂₃₂, der sich in der Regel vom Wellenwiderstand Z₂₃₀ der ersten Hochfrequenzleitung 230 dadurch unterscheidet, dass er hochohmiger ist. Die zweite Hochfrequenzleitung 232 hat ferner eine optimierte Länge und ist elektromagnetisch mit der vierten Hochfrequenzleitung 236 gekoppelt.

Die Hochfrequenzleitungen 234 und 236 entsprechen hinsichtlich ihrer Länge und ihrem Wellenwiderstand vorzugsweise den Hochfrequenzleitungen 230 und 232. Die Hochfrequenzleitungen 234 und 236 befinden sich zwischen dem Ausgangstor 224 und dem zweiten Knoten 208 und zwischen den Hochfrequenzleitungen 232 und 236 befindet sich das induktive Bauelement 226, das gegen das Bezugspotential 228 verschaltet ist und beispielsweise als Leitungsbauelement oder konzentriertes Bauelement realisiert ist, wobei in diesem Fall das induktive Bauelement als SMD-Bauelement realisiert ist (SMD = Surface Mounted Device = oberflächenbefestigbares Bauelement).

Unter der Annahme, dass die beiden Anschlusstore 214 und 220, welche beispielsweise Mikrowellentore sein können, die gleiche Referenzimpedanz aufweisen, muss die erste Hochfrequenzleitung 230 hinsichtlich ihres Wellenwiderstands und der elektrischen Länge der dritten Hochfrequenzleitung 234 entsprechen. Gleiches gilt für die Hochfrequenzleitungen 232 und 236. In diesem Fall muss die Filterschaltung bezüglich der vertikalen Mittelachse 238 spiegelsymmetrisch sein.

Bei beliebigen Referenzimpedanzen der beiden Tore 214 und 220 kann die Filterschaltung zur Impedanztransformation herangezogen werden, wobei in diesem Fall die Symmetrieeigenschaften nicht mehr vorliegen.

Sofern eine Verbesserung der Selektionseigenschaften der in Fig. 5 gezeigten Filteranordnung erwünscht ist, müssen alternierend zusätzliche Serienleitungen und induktive Bauelemente, die gegen Masse geschaltet sind, eingefügt werden. Zwar müssen nicht sämtliche hochohmigen Leitungen miteinander koppeln, jedoch ergibt sich eine Verbesserung der Selektionseigenschaften mit zunehmendem Anteil der verkoppelten Leitungen.

Hinsichtlich der in den Resonatoreinrichtungen 202 und 204 vorgesehenen Hochfrequenzleitungen 230, 232, 234 und 236 wird darauf hingewiesen, dass die Leitungen auch in, verglichen mit Fig. 5, umgekehrter Reihenfolge angeordnet sein können. Ferner kann jede Resonatoreinrichtung eine beliebige Anzahl von verkoppelten und/oder unverkoppelten Hochfrequenzleitungen umfassen.

Anstelle der in Fig. 5 beschriebenen Leitungen können auch alle anderen Resonatoren eingesetzt werden, sofern diese miteinander verkoppelbar sind und im Durchlassbereich eine Serienresonanz (Durchlassverhalten) aufweisen. Die in Fig. 5 gezeigte Topologie ist eine sogenannte Komplementärstruktur zu der in Fig. 1 beschriebenen Struktur.

Anhand der Fig. 6 wird ein Ausführungsbeispiel einer Filteranordnung beschrieben, bei der, verglichen mit Fig. 5, beide Tore 214 und 220 symmetrische Tore sind. Die in Fig. 6 gezeigte Anordnung umfasst parallel zu der symmetrischen Leitung 248 in der symmetrischen Leitung 250 eine dritte Resonatoreinrichtung 280 und eine vierte Resonatoreinrichtung 282. Die dritte Resonatoreinrichtung 280 ist zwischen den vierten Knoten 212 und einen fünften Knoten 284 geschaltet und die vierte Resonatoreinrichtung 282 ist zwischen den vierten Knoten 212 und einen sechsten Knoten 286 geschaltet. Der fünfte Knoten 284 ist mit dem zweiten Eingangstorknoten 218 verbunden und der sechste Knoten 286 ist mit dem zweiten Ausgangstorknoten 224 verbunden.

Die dritte Resonatoreinrichtung 280 umfasst eine fünfte Hochfrequenzleitung 288 und eine sechste Hochfrequenzleitung 290, die seriell zwischen dem fünften Knoten 284 und dem zweiten Knoten 212 angeordnet sind. Die vierte Resonatoreinrichtung 282 umfasst eine siebte Hochfrequenzleitung 292 und eine achte Hochfrequenzleitung 294, die seriell zwischen den sechsten Knoten 286 und den vierten Knoten 212 geschaltet sind. Wie durch den Pfeil in Fig. 6 zu erkennen ist, sind die Hochfrequenzleitungen 290 und 294 elektromagnetisch verkoppelt.

Fig. 6 zeigt eine Bandpassfilteranordnung, bei der die Eingangs- und Ausgangstore 214 und 220 jeweils ein symmetrisches Tor, z. B. ein Mikrowellentor, sind. Die Filtertopologie besteht in diesem Fall darin, dass hinter dem Eingangstor 214 zwei doppelte Serienleitungen mit einer Länge von weniger als λ/4 geschaltet sind, die hier durch die Leitungen 230, 232, 288 und 290 gebildet sind. Ferner ist das parallele induktive Bauelement 226 sowie zwei weitere Leitungspaare, die durch die Hochfrequenzleitungen 234, 236, 292, 294 gebildet sind, vorgesehen. Das besondere an dieser Topologie ist, dass die Filterschaltung bezüglich der horizontalen Mittelachse 246 spiegelsymmetrisch ist, d. h. die Längen uhd Wellenwiderstände der oberen Leitungen 230 bis 236 gleichen den Längen und Wellenwiderständen der unteren Leitungen 288 bis 294.

Unter der Annahme, dass die beiden Tore 214 und 220 die gleiche Referenzimpedanz aufweisen, muss die Schaltung auch bezüglich der vertikalen Mittelachse 238 spiegelsymmetrisch sein, d. h., dass die Hochfrequenzleitung 230 hinsichtlich ihres Wellenwiderstands und ihrer elektrischen Länge der Hochfrequenzleitung 234 entspricht. Gleiches gilt für die Hochfrequenzleitungen 232, 288, 290, die hinsichtlich ihrer Wellenwiderstände und elektrischen Längen den Hochfrequenzleitungen 236, 292 und 294 gleichen.

Bei beliebigen Torimpedanzen kann die Filteranordnung zur Impedanztransformation herangezogen werden, wobei in diesem Fall die oben erwähnten Symmetrieeigenschaften nicht mehr gegeben sind.

Soll eine Verbesserung der Selektionseigenschaften der Filteranordnung erreicht werden, so müssen alternierend zusätzlich Serienleitungen und induktive Bauelemente, die zwischen die symmetrischen Leitungen 248 und 250 geschaltet werden, eingefügt werden. Obwohl nicht sämtliche Leitungen miteinander koppeln müssen, lässt sich die Selektionseigenschaft mit steigendem Anteil der verkoppelten Leitungen weiter verbessern.

Die in Fig. 6 dargestellte Reihenfolge der Leitungen in den einzelnen Resonatoreinrichtungen 202, 204, 280 und 282 kann auch vertauscht sein. Ferner können in den Resonatoreinrichtungen eine beliebig große Anzahl verkoppelter und/oder unverkoppelter Hochfrequenzleitungen vorgesehen sein.

Anstelle der in Fig. 6 beschriebenen verkoppelten Leitungen können auch alle anderen Resonatoren eingesetzt werden, sofern sich diese miteinander verkoppeln lassen und im Durchlassbereich eine Serienresonanz (ein Durchlassverhalten) aufweisen.

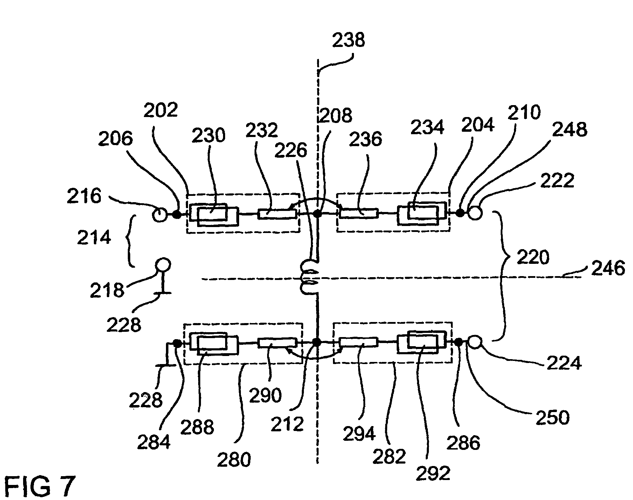

In Fig. 7 ist ein weiteres Ausführungsbeispiel eines Resonatorbandpassfilters dargelegt, bei dem das Eingangstor ein unsymmetrisches Tor und das Ausgangstor ein symmetrisches Tor ist.

Im wesentlichen entspricht die Struktur der Schaltung in Fig. 7 derjenigen aus Fig. 6, wobei hier jedoch, anders als in Fig. 6, der zweite Eingangstorknoten 218 mit dem Bezugspotential 228, z. B. Masse, verbunden ist. Ebenso ist der fünfte Knoten 284 mit dem Bezugspotential 228 verbunden. Mit andern Worten erstreckt sich, im Gegensatz zu Fig. 6, hier nur die erste symmetrische Leitung 248 zwischen dem Eingangstor und dem Ausgangstor, wohingegen sich die zweite symmetrische Leitung 250 von dem zweiten Ausgangstorknoten 224 über die Knoten 286, 212 und 284 zum Bezugspotential 228 erstreckt.

Bei dem in Fig. 7 dargestellten Bandpassfilter ist der Eingangsanschluss 214 ein unsymmetrisches Tor und der Ausgangsanschluss 220 ist ein symmetrisches Tor. Die Filtertopologie besteht in diesem Fall darin, dass hinter dem Eingangstor 214 zwei Leitungspaare (Hochfrequenzleitungen 230, 232, 288, 290), ein paralleles induktives Bauelement 226 und zwei weitere Leitungspaare (Hochfrequenzleitungen 234, 236, 292, 294) geschaltet sind.

Das besondere an dieser Topologie besteht darin, dass die Filterschaltung bezüglich der horizontalen Mittelachse 264 spiegelsymmetrisch ist, d. h., dass sich die oberen Leitungen 230 bis 236 und die unteren Leitungen 288 bis 294 hinsichtlich ihres elektrischen Verhaltens, Wellenlänge und elektrische Länge, gleichen.

Unter der Annahme, dass die Impedanz des Eingangstors 214 der Hälfte der Impedanz des Ausgangstors 220 entspricht, muss die Hochfrequenzleitung 230 hinsichtlich ihres Wellenwiderstands und ihrer elektrischen Länge der Hochfrequenzleitung 234 entsprechen. Gleiches gilt für die Hochfrequenzleitungen 232, 288 und 290, die hinsichtlich ihrer elektrischen Eigenschaften den Hochfrequenzleitungen 236, 292 und 294 entsprechen müssen. Die Schaltung muss also bezüglich der vertikalen Mittelachse 238 symmetrisch sein.

Unter der Annahme beliebiger Torimpedanzen am Eingangstor 214 und 220 kann das Filter zur Impedanztransformation herangezogen werden, wobei in diesem Fall die oben erwähnten Symmetrieeigenschaften nicht mehr gegeben sind.

Zur Verbesserung der Filtereigenschaften, wie beispielsweise der Selektionseigenschaften, müssen alternierend zusätzliche Serienleitungen und induktive Bauelemente, die zwischen die symmetrischen Leitungen 248 und 250 geschaltet sind, eingefügt werden. Obwohl nicht sämtliche hochohmigen Leitungen miteinander koppeln müssen, lässt sich die Selektionseigenschaft des Filters abhängig von der Anzahl der verkoppelten Leitungen verbessern.

Wie auch bei dem Ausführungsbeispiele, das anhand der Fig. 6 beschrieben wurde, können bei den Resonatoreinrichtungen die Reihenfolge der Hochfrequenzleitungen umgedreht werden. Ferner können die Resonatoreinrichtungen eine beliebig große Anzahl verkoppelter und/oder unverkoppelter Hochfrequenzleitungen aufweisen.

Anstelle der verkoppelten Leitungen 230 bis 236 und 288 bis 294 können auch alle anderen Resonatoren eingesetzt werden, sofern sich diese miteinander verkoppeln lassen und im Durchlassbereich eine Serienresonanz (Durchlassverhalten) aufweisen.

Hinsichtlich der oben anhand der Fig. 2 bis 4, 6 und 7 näher beschriebenen Ausführungsbeispiele wird darauf hingewiesen, dass für sämtliche Filteranordnungen gilt, dass für die elektromagnetische Kopplung beide möglichen Richtungen benutzt werden können. Oft werden diese Verkopplungen mit einem Punkt am Bauelement (Leitung oder Spule) gekennzeichnet. In diesem Fall können die beiden Punkte links bzw. rechts oder innen bzw. außen liegen.

Generell gilt für alle oben beschriebenen Ausführungsbeispiele, dass das Eingangstor 114, 214 und das Ausgangstor 120, 220 immer vertauscht werden können. Anstatt der kapazitiv wirkenden Leitungen können konzentrierte Kapazitäten in der Form von Chipkondensatoren oder ähnlichem eingesetzt werden, wobei im Fall der anhand der Fig. 2 und 3 beschriebenen Ausführungsbeispiele diese Kondensatoren zwischen die Signalleitung und Masse geschaltet sind, und im Fall der anhand der Fig. 6 und 7 beschriebenen Ausführungsbeispiele diese Kondensatoren seriell verschaltet sind.

Es wird darauf hingewiesen, dass es sich bei den beschriebenen Eingangs/Ausgangstoren nicht um Mikrowellentore handeln muss, sondern dass jedes in der allgemeinen Netzwerktheorie definierte Tor umfasst ist. Setzt man Quarzresonatoren ein, so kann man die erfindungsgemäße Topologie auch bei tiefen Frequenzen nutzen. Verwendet man optische Resonatoren, so kann man das Konzept auch in der Optik einsetzen.

Der Aufbau aus Serienleitungen bzw. Serienresonatoren und Parallelleitungen bzw. Parallelresonatoren kann ab der minimalen Ausbaustufe der oben beschriebenen Grundzellen mit drei Elementen auch miteinander in einer Kettenschaltung zusammengefügt werden. Einige Filter weisen eine Serien- und Parallelresonanz auf, die sehr nahe zusammen liegen, so dass für derartige Filter eine Resonatorzelle für die beiden Einsatzfälle verwendet werden kann.

Die in den in den Fig. 2 und 3 beschriebenen Ausführungsbeispielen verwendeten gekoppelten Hochfrequenzleitungen 232 und 236 können halbiert werden, und das in den Fig. 6 und 7 beschriebene induktive Bauelement 246 kann durch zwei induktive Bauelemente mit dem doppelten Wert ersetzt werden, und dann werden diese für die Schaltungen mit symmetrischen Toren in der Symmetrieebene 246 mit Masse kontaktiert, wodurch man die symmetrischen Leitungssysteme in eine Symmetrie gegen Masse legt.

Die kapazitiven Leitungen der Resonatoren, nämlich die Leitungen 130,230, 134,234, 142,288 und 144,292, werden vorteilhafterweise durch zwei übereinander liegende, niederohmige Leitungen realisiert.

Bei den oben beschriebenen Schaltungen gemäß der vorliegenden Erfindung sind die kapazitiven Leitungen der Resonatoren, nämlich die Leitungen 130,230, 134,234, 142,288 und 144,292, werden durch zwei übereinander liegende, niederohmige Leitungen realisiert.

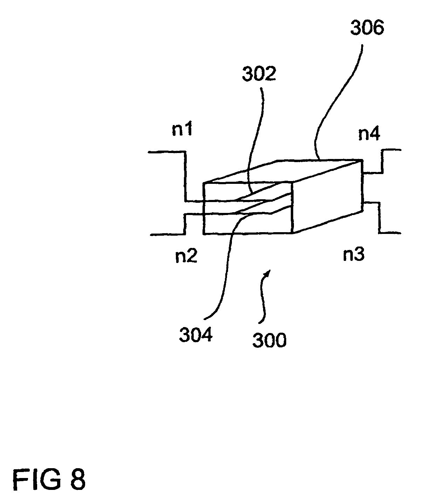

Fig. 8 zeigt schematisch eine gekoppelte Hochfrequenzleitung. Zwischen einem ersten Tor, das durch die Anschlüsse n1 und n2 gebildet ist, und einem zweiten Tor, das durch die Anschlüsse n3 und n4 gebildet ist, ist die gekoppelte Hochfrequenzleitung 300 angeordnet. Die Hochfrequenzleitung 300 umfasst eine erste Leitung 302 und eine parallel dazu angeordnete zweite Zeitung 304, die beide in einem isolierenden Gehäuse 306, das mit einem Bezugspotential, z.B. Masse, verbunden ist, angeordnet sind. Die erste Leitung 302 ist zwischen den Anschluss n1 und den Anschluss n4 geschaltet, und die zweite Leitung 302 ist zwischen den Anschluss n2 und den Anschluss n3 geschaltet. Die Leitungen 302 haben eine Länge, die mit "P" bezeichnet ist, eine Breite, die mit "W" bezeichnet ist, und einen vertikalen Abstand von den durch das Gehäuse 306 gebildeten Masseflächen, der mit S bezeichnet ist. Die Längen und Breiten der Leitungen 302 und 304 sind vorzugsweise gleich.

Die kapazitiven Leitungen 130,230, 134,234, 142,288 und 144,292 der Resonatoren sind durch die Leitungen 302 und 304 realisiert. Bei den verkoppelten Leitungen der Resonatoren sind die Hochfrequenzleitungen 132, 232, und 290 sind durch die erste Leitung 302 und die Hochfrequenzleitungen 136, 236 und 294 durch die zweite Leitung 304 gebildet.

Gemäß einem Ausführungsbeispiel haben die beschriebenen Bandpassfilter einen Durchlassbereich von etwa 1,7 GHz bis etwa 2,0 GHz. Die Resonatoren weisen die anhand der Fig. 8 beschriebenen Leitungen auf, und deren Elemente sind für diesen Frequenzbereich optimiert.

Gemäß einem Ausführungsbeispiel der vorliegenden Erfindung, bei dem an den Toren der Schaltungen gleiche Impedanzen vorliegen, z.B. 50Ω, liegt die Induktivität der verwendeten induktiven Bauelemente zwischen 1nH und 10nH, die Länge der kapazitiven Leitungen ist zwischen 0,1mm und 0,8mm, die Bereite der gekoppelten Leitungen ist zwischen 0,1mm und 0,8mm, die Länge der gekoppelten Leitungen ist zwischen 3,0mm und 8mm, und die Breite der gekoppelten Leitungen ist zwischen 0,06mm und 0,2mm. Der Abstand der Leitungen von der Massefläche beträgt vorzugsweise etwa 0,02mm. Die kapazitiven Leitungen am Eingang und am Ausgang haben in diesem Fall gleiche Abmessungen.

Gemäß einem weitern Ausführungsbeispiel der vorliegenden Erfindung, bei dem an den Toren der Schaltungen unterschiedliche Impedanzen vorliegen, z.B. 50Ω und 25Ω, liegt die Induktivität der verwendeten induktiven Bauelemente zwischen 1nH und 10nH, die Länge der kapazitiven Leitungen ist zwischen 0,1mm und 0,8mm, die Bereite der gekoppelten Leitungen ist zwischen 0,1mm und 0,8mm, die Länge der gekoppelten Leitungen ist zwischen 3,0mm und 8mm, und die Breite der gekoppelten Leitungen ist zwischen 0,06mm und 0,2mm. Der Abstand der Leitungen von der Massefläche beträgt vorzugsweise etwa 0,02mm.

Die kapazitiven Leitungen am Eingang und am Ausgang haben in diesem Fall nicht die gleichen Abmessungen.

Beispielhaft sei nun nochmals die Fig. 5 betrachtet. Es sei angenommen, dass die kapazitiven Leitungen 230 und 234 jeweils durch eine der in Fig. 8 gezeigten Leitungen 300 gebildet seien. Die gekoppelten Leitungen 232, 236 sein durch eine gemeinsame Leitung 300 (Fig. 8) gebildet.

Unter der Annahme gleicher Impedanzen von 50Ω am Eingangstor 214 und am Ausgangstor 220 haben die Elemente die folgenden optimierten Werte für einen Durchlassbereich von 1,71GHz bis 1,99GHz:

Die Breiten "W" der Leitungen des ersten Hochfrequenzleitungspaares 230 und die Breitren "W" der Leitungen des zweiten Hochfrequenzleitungspaares 234 sind gleich und betragen 0,41296mm. Die Längen "P" der Leitungen 302, 304 des ersten Hochfrequenzleitungspaares 230 und die Längen "P" des zweiten Hochfrequenzleitungspaares 234 sind gleich und betragen 0,41296mm.

Die Breite "W" der Hochfrequenzleitung 232 und die Breite "W" des zweiten Hochfrequenzleitungspaares 236 sind gleich und betragen 0,06552mm. Die Länge "P" der Hochfrequenzleitung 232 und die Länge der zweiten Hochfrequenzleitung 236 sind gleich und betragen 4,169mm.

Der Abstand aller Leitungen zu der Massefläche beträgt 0,02mm.

Das induktive Bauelement 226 hat eine Induktivität von 3,1891nH.

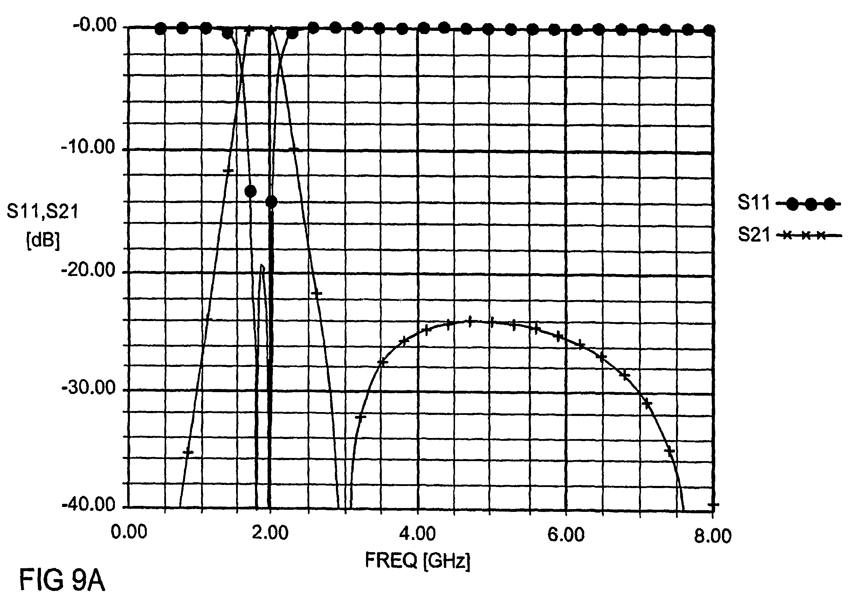

Die obigen Werte der Elemente ergeben sich aus einer Optimierung des Reflexionsfaktors und der Durchlassdämpfung im Durchlassbereich des Filters, mit S₁₁ = -21dB und S₂₁ = 0dB im Durchlassbereich, und S₂₁ = -22dB außerhalb des Durchlassbereichs. Fig. 9A zeigt den Verlauf von Reflexionsfaktor (S₁₁) und Durchlassdämpfung (S₂₁) über den Frequenzbereich von 0GHz bis 8GHz.

Unter der Annahme einer Impedanz von 50Ω am Eingangstor 214 und einer Impedanz von 25Ω am Ausgangstor 220 (oder umgekehrt) haben die Elemente die folgenden optimierten Werte für einen Durchlassbereich von 1,71GHz bis 1,99GHz (Impedanztransformation):

Die Breiten "W" der Leitungen des ersten Hochfrequenzleitungspaares 230 betragen 0,49379mm, und die Breitren "W" der Leitungen des zweiten Hochfrequenzleitungspaares 234 betragen 0,53553mm. Die Längen "P" der Leitungen 302, 304 des ersten Hochfrequenzleitungspaares 230 betragen 0,49379mm, und die Längen "P" des zweiten Hochfrequenzleitungspaares 234 betragen 0,53553mm.

Die Breite "W" der Hochfrequenzleitung 232 und die Breite "W" des zweiten Hochfrequenzleitungspaares 236 sind gleich und beträgt 0,10583mm. Die Länge "P" der Hochfrequenzleitung 232 und die Länge der zweiten Hochfrequenzleitung 236 sind gleich und beträgt 3,576mm.

Der Abstand aller Leitungen zu der Massefläche beträgt 0,02mm.

Das induktive Bauelement 226 hat eine Induktivität von 2,5432nH.

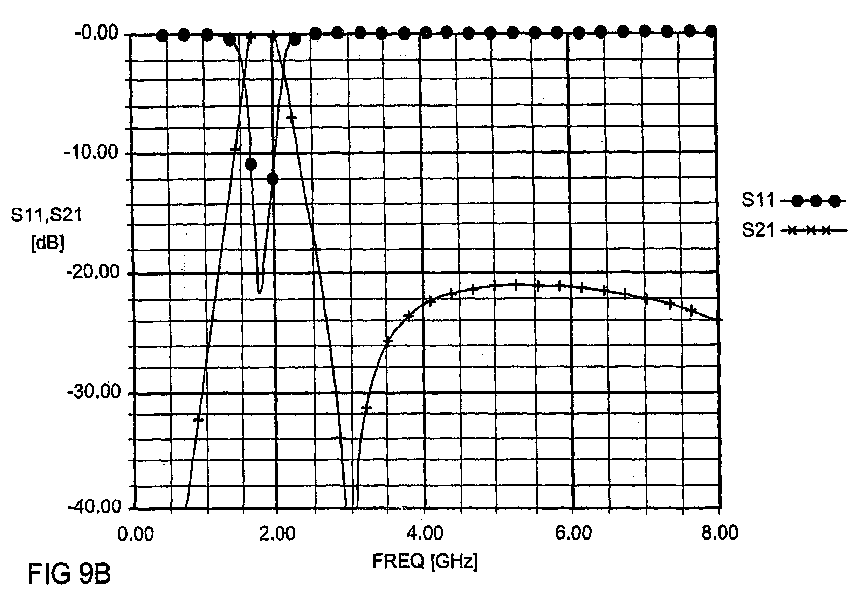

Die obigen Werte der Elemente ergeben sich aus einer Optimierung des Reflexionsfaktors und der Durchlassdämpfung im Durchlassbereich des Filters, mit S₁₁ = -21dB und S₂₁ = 0dB im Durchlassbereich, und S₂₁ = -22dB außerhalb des Durchlassbereichs. Fig. 9B zeigt den Verlauf von Reflexionsfaktor (S₁₁) und Durchlassdämpfung (S₂₁) über den Frequenzbereich von 0GHz bis 8GHz.

### Bezugszeichenliste

- 102, 202: erste Resonatoreinrichtung
- 104, 204: zweite Resonatoreinrichtung
- 106, 206: erster Knoten
- 108, 208: zweiter Knoten
- 110, 210: dritter Knoten
- 112, 212: vierter Knoten
- 114, 214: Eingangstor
- 116, 216: erster Eingangstorknoten
- 118, 218: zweiter Eingangstorknoten
- 120, 220: Ausgangstor
- 122, 222: erster Ausgangstorknoten
- 124, 224: zweiter Ausgangstorknoten
- 126, 226: induktives Bauelement
- 128, 228: Bezugspotential
- 130, 230: erste Hochfrequenzleitung
- 132, 232: zweite Hochfrequenzleitung
- 134, 234: dritte Hochfrequenzleitung
- 136, 236: vierte Hochfrequenzleitung
- 138, 238: vertikale Mittelachse
- 140: weiteres induktives Bauelement
- 142: fünfte Hochfrequenzleitung
- 144: sechste Hochfrequenzleitung
- 146, 246: horizontale Mittelachse
- 148, 248: erste symmetrische Leitung
- 150, 250: zweite symmetrische Leitung
- 152: erster Resonator
- 154: zweiter Resonator
- 156: dritter Resonator
- 158: vierter Resonator
- 160: dritte Resonatoreinrichtung
- 162: fünfter Resonator
- 164: sechster Resonator
- 166: fünfter Knoten
- 168: sechster Knoten
- 170: weiteres induktives Bauelement
- 172: weiteres induktives Bauelement
- 280: dritte Resonatoreinrichtung
- 282: vierte Resonatoreinrichtung
- 284: fünfter Knoten
- 286: sechster Knoten
- 288: fünfte Hochfrequenzleitung
- 290: sechste Hochfrequenzleitung
- 292: siebte Hochfrequenzleitung
- 294: achte Hochfrequenzleitung
- 300: Hochfrequenzleitung
- 302: erste Leitung
- 304: zweite Leitung
- 306: Gehäuse

## Patentansprüche

1. Filteranordnung mit
einer ersten Resonatoreinrichtung (102), die zwischen einen ersten Knoten (106) und einen zweiten Knoten (108) geschaltet ist;
einer zweiten Resonatoreinrichtung (104), die zwischen einen dritten Knoten (110) und einen vierten Knoten (112) geschaltet ist, wobei die erste Resonatoreinrichtung (102) und die zweite Resonatoreinrichtung (104) elektromagnetisch verkoppelt sind; und
einem induktiven Bauelement (126), das zwischen den ersten Knoten (106) und den dritten Knoten (110) geschaltet ist;
**gekennzeichnet durch**
ein weiteres induktives Bauelement (140), das zwischen den zweiten Knoten (108) und den vierten Knoten (112) geschaltet ist;
wobei die erste Resonatoreinrichtung (102) und die zweite Resonatoreinrichtung (104) Leitungs-Resonatoren, BAW-Resonatoren, SAW-Resonatoren, dielektrische Resonatoren, Quarzresonatoren und/oder optische Resonatoren umfassen.

2. Filteranordnung gemäß Anspruch 1, bei der die erste Resonatoreinrichtung (102) und die zweite Resonatoreinrichtung (104) im Durchlassbereich eine Parallelresonanz aufweisen und gekoppelt sind.

3. Filteranordnung gemäß Anspruch 1 oder 2 mit einem ersten Tor (114) mit einem ersten Torknoten (116), der mit dem ersten Knoten (106) verbunden ist, und einem zweiten Torknoten (118), der mit dem zweiten Knoten (108) verbunden ist, einem zweiten Tor (120) mit einem dritten Torknoten (122), der mit dem dritten Knoten (110) verbunden ist, und einem vierten Torknoten (124), der mit dem vierten Knoten (112) verbunden ist.

4. Filteranordnung gemäß Anspruch 1 oder 2 mit einem ersten Tor (114) mit einem ersten Torknoten (116), der mit dem ersten Knoten (106) verbunden ist, und einem zweiten Torknoten (118), der mit einem Bezugspotential (128) verbunden ist, einem zweiten Tor (120) mit einem dritten Torknoten (122), der mit dem dritten Knoten (110) verbunden ist, und einem vierten Torknoten (124), der mit dem vierten Knoten (112) verbunden ist.

5. Filteranordnung gemäß einem der Ansprüche 1 bis 4, bei der die erste Resonatoreinrichtung (102) ein erstes kapazitives Element (130) und ein erstes Leitungselement (132) umfasst, und bei der die zweite Resonatoreinrichtung (104) ein zweites kapazitives Element (134) und ein zweites Leitungselement (136) umfasst.

6. Filteranordnung gemäß Anspruch 5, bei der das erste kapazitive Element und das zweite kapazitive Element durch einen Kondensator, der gegen ein Bezugspotential verschaltet ist, durch eine kapazitive Leitung oder durch eine leerlaufende Stichleitung gebildet sind.

7. Filteranordnung gemäß Anspruch 5 oder 6, bei der die erste Resonatoreinrichtung (102) ein weiteres kapazitives Element (142) aufweist, das zwischen das erste Leitungselement (132) und den zweiten Knoten (108) geschaltet ist, und die zweite Resonatoreinrichtuhg (104) ein weiteres kapazitives Element (144) aufweist, das zwischen das zweite Leitungselement (136) und den vierten Knoten (112) geschaltet ist.

8. Filteranordnung gemäß Anspruch 7, bei der das weitere kapazitive Element (142, 144) eine kapazitive Leitung ist.

9. Filteranordnung gemäß einem der Ansprüche 1 bis 4, bei der die erste Resonatoreinrichtung (102) und die zweite Resonatoreinrichtung (104) jeweils zumindest einen Resonator (152, 154, 156, 158) aufweisen.

10. Filteranordnung gemäß Anspruch 9,
bei der das induktive Bauelement ein erstes induktives Bauelement (126), das zwischen den ersten Knoten (106) und einen fünften Knoten (166) geschaltet ist, und ein zweites induktives Bauelement (170), das zwischen den dritten Knoten (110) und den fünften Knoten (166) geschaltet ist, umfasst;
bei der das weitere induktive Bauelement ein drittes induktives Bauelement (140), das zwischen den zweiten Knoten (108) und einen sechsten Knoten (168) geschaltet ist, und ein viertes induktives Bauelement (172), das zwischen den vierten Knoten (112) und den sechsten Knoten (168) geschaltet ist, umfasst; und
bei der eine weitere Resonatoreinrichtung (160), die mit der ersten Resonatoreinrichtung (102) und mit der zweiten Resonatoreinrichtung (104) gekoppelt ist, zwischen den fünften Knoten (166) und den sechsten Knoten (168) geschaltet ist.

11. Filteranordnung gemäß Anspruch 10, bei der die erste, die zweite und die weitere Resonatoreinrichtung (102, 104, 106) eine Mehrzahl von verkoppelten Resonatoren (152, 154, 156, 158, 162, 164) umfasst.

12. Filteranordnung mit
einer ersten Resonatoreinrichtung (202), die zwischen einen ersten Knoten (206) und einen zweiten Knoten (208) geschaltet ist;
einer zweiten Resonatoreinrichtung (204), die zwischen den zweiten Knoten (208) und einen dritten Knoten (210) geschaltet ist, wobei die erste Resonatoreinrichtung (202) und die zweite Resonatoreinrichtung (204) elektromagnetisch verkoppelt sind; und
einem induktiven Bauelement (226), das zwischen den zweiten Knoten (208) und einen vierten Knoten (212) geschaltet ist;
**gekennzeichnet durch**
eine dritte Resonatoreinrichtung (280), die zwischen einen fünften Knoten (284) und den vierten Knoten (212) geschaltet ist; und
eine vierte Resonatoreinrichtung (282), die zwischen einen sechsten Knoten (286) und den vierten Knoten (212) geschaltet ist, wobei die dritte Resonatoreinrichtung (280) und die vierte Resonatoreinrichtung (282) elektromagnetisch verkoppelt sind;
wobei die erste Resonatoreinrichtung (102) und die zweite Resonatoreinrichtung (104) Leitungs-Resonatoren, BAW-Resonatoren, SAW-Resonatoren, dielektrische Resonatoren, Quarzresonatoren und/oder optische Resonatoren umfassen.

13. Filteranordnung gemäß Anspruch 12, bei der die erste Resonatoreinrichtung (202) und die zweite Resonatoreinrichtung (204) im Durchlassbereich eine Serienresonanz aufweisen und gekoppelt sind.

14. Filteranordnung gemäß Anspruch 12 oder 13 mit einem ersten Tor (214) mit einem ersten Torknoten (216), der mit dem ersten Knoten (206) verbunden ist, und einem zweiten Torknoten (218), der mit dem fünften Knoten (284) verbunden ist, einem zweiten Tor (220) mit einem dritten Torknoten (222), der mit dem dritten Knoten (210) verbunden ist, und einem vierten Torknoten (224), der mit dem sechsten Knoten (286) verbunden ist.

15. Filteranordnung gemäß Anspruch 12 oder 13 mit einem ersten Tor (214) mit einem ersten Torknoten (216), der mit dem ersten Knoten (206) verbunden ist, und einem zweiten Torknoten (218), der mit einem Bezugspotential (228) verbunden ist, einem zweiten Tor (220) mit einem dritten Torknoten (222), der mit dem dritten Knoten (210) verbunden ist, und einem vierten Torknoten (224), der mit dem sechsten Knoten (286) verbunden ist.

16. Filteranordnung gemäß einem der Ansprüche 12 bis 15, bei der jede Resonatoreinrichtung (202, 204, 280, 282) ein kapazitives Element (230, 234, 288, 292) und ein Leitungselement (232, 236, 290, 294) umfasst.

17. Filteranordnung gemäß Anspruch 16, bei der das kapazitive Element durch einen Kondensator, der seriell verschaltet ist, durch eine kapazitive Leitung oder durch eine leerlaufende Stichleitung gebildet ist.

18. Filteranordnung gemäß einem der Ansprüche 12 bis 17, bei der die Resonatoreinrichtungen (202, 204, 280, 282) jeweils zumindest einen Resonator aufweisen.

## Claims

1. Filter arrangement, comprising
a first resonator means (102) connected between a first node (106) and a second node (108);
a second resonator means (104) connected between a third node (110) and a fourth node (112), wherein the first resonator means (102) and the second resonator means (104) are coupled electro-magnetically; and
an inductive device (126) connected between the first node (106) and the third node (110);
**characterized by**
a further inductive device (140) connected between the second node (108) and the fourth node (112);
wherein the first resonator means (102) and the second resonator means (104) include line resonators, BAW resonators, SAW resonators, dielectric resonators, quartz resonators and/or optical resonators.

2. Filter arrangement according to claim 1, wherein the first resonator means (102) and the second resonator means (104) have a parallel resonance in the passband and are coupled.

3. Filter arrangement according to claim 1 or 2, comprising a first port (114) with a first port node (116) connected to the first node (106), and a second port node (118) connected to the second node (108), a second port (120) with a third port node (122) connected to the third node (110), and a fourth port node (124) connected to the fourth node (112).

4. Filter arrangement according to claim 1 or 2, comprising a first port (114) with a first port node (116) connected to the first node (106), and a second port node (118) connected to a reference potential (128), a second port (120) with a third port node (122) connected to the third node (110) and a fourth port node (124) connected to the fourth node (112).

5. Filter arrangement according to one of claims 1 to 4, wherein the first resonator means (102) includes a first capacitive element (130) and a first line element (132), and wherein the second resonator means (104) includes a second capacitive element (134) and a second line element (136).

6. Filter arrangement according to claim 5, wherein the first capacitive element and the second capacitive element are formed by a capacitor interconnected against a reference potential, by a capacitive line, or by an open tap line.

7. Filter arrangement according to claim 5 or 6, wherein the first resonator means (102) comprises a further capacitive element (142) connected between the first line element (132) and the second node (108), and wherein the second resonator means (104) comprises a further capacitive element (144) connected between the second line element (136) and the fourth node (112).

8. Filter arrangement according to claim 7, wherein the additional capacitive element (142, 144) is a capacitive line.

9. Filter arrangement according to one of claims 1 to 4, wherein the first resonator means (102) and the second resonator means (104) each comprise at least one resonator (152, 154, 156, 158).

10. Filter arrangement according to claim 9,
wherein the inductive device includes a first inductive device (126) connected between the first node (106) and a fifth node (166), and a second inductive device (170) connected between the third node (110) and the fifth node (166);
wherein the additional inductive device includes a third inductive device (140) connected between the second node (108) and a sixth node (168), and a fourth inductive device (172) connected between the fourth node (112) and the sixth node (168); and
wherein a further resonator means (160) coupled to the first resonator means (102) and to the second resonator means (104) is connected between the fifth node (166) and the sixth node (168).

11. Filter arrangement according to claim 10, wherein the first, the second and the additional resonator means (102, 104, 106) includes a plurality of coupled resonators (152, 154, 156, 158, 162, 164).

12. Filter arrangement, comprising
a first resonator means (202), connected between a first node (206) and a second node (208);
a second resonator means (204) connected between the second node (208)and a third node (210), wherein the first resonator means (202) and the second resonator means (204) are electro-magnetically coupled; and
an inductive device (226) connected between the second node (208) and a fourth node (212);
**characterized by**
a third resonator means (280), connected between a fifth node (284) and the fourth node (212); and
a fourth resonator means (282) connected between a sixth node (286) and the fourth node (212), wherein the third resonator means (280) and the fourth resonator means (282) are electro-magnetically coupled;
wherein the first resonator means (102) and the second resonator means (104) include line resonators, BAW resonators, SAW resonators, dielectric resonators, quartz resonators and/or optical resonators.

13. Filter arrangement according to claim 12, wherein the first resonator means (202) and the second resonator means (204) have a serial resonance in the passband and are coupled.

14. Filter arrangement according to claim 12 or 13, comprising a first port (214) with a first port node (216) connected to the first node (206), and a second port node (218) connected to the fifth node (284), a second port (220) with a third port node (222) connected to the third node (210), and a fourth port node (224) connected to the sixth node (286).

15. Filter arrangement according to claim 12 or 13 having a first port (214) with a first port node (216) connected to the first node (206), and a second port node (218) connected to a reference potential (228), a second port (220) with a third port node (222) connected to the third node (210), and a fourth port node (224) connected to the sixth node (286).

16. Filter arrangement according to one of claims 12 to 15, wherein each resonator means (202, 204, 280, 282) includes one capacitive element (230, 234, 288, 292) and one line element (232, 236, 290, 294).

17. Filter arrangement according to claim 16, wherein the capacitive element is formed by a serially connected capacitor, by a capacitive line or by an open tap line.

18. Filter arrangement according to one of claims 12 to 17, wherein the resonator means (202, 204, 280, 282) each comprise at least one resonator.

## Revendications

1. Dispositif de filtrage comportant
un premier dispositif résonateur (102), qui est branché entre un premier noeud (106) et un deuxième noeud (108) ;
un deuxième dispositif résonateur (104), qui est branché entre un troisième noeud (110) et un quatrième noeud (112), le premier dispositif résonateur (102) et le deuxième dispositif résonateur (104) étant couplés d'un point de vue électromagnétique ; et
un élément inductif (126), qui est branché entre le premier noeud (106) et le troisième noeud (110) ;
**caractérisé par**
un autre élément inductif (140), qui est branché entre le deuxième noeud (108) et le quatrième noeud (112) ;
le premier dispositif résonateur (102) et le deuxième dispositif résonateur (104) comprenant des résonateurs de ligne, des résonateurs BAW, des résonateurs SAW, des résonateurs diélectriques, des résonateurs à quartz et/ou des résonateurs optiques.

2. Dispositif de filtrage selon la revendication 1, dans lequel le premier dispositif résonateur (102) et le deuxième dispositif résonateur (104) dans la bande passante comportent une résonance parallèle et sont couplés.

3. Dispositif de filtrage selon la revendication 1 ou 2, comportant une première porte (114) avec un premier noeud de porte (116) qui est relié au premier noeud (106) et avec un deuxième noeud de porte (118) qui est relié au deuxième noeud (108) et une deuxième porte (120) avec un troisième noeud de porte (122) qui est relié au troisième noeud (110) et avec un quatrième noeud de porte (124) qui est relié au quatrième noeud (112).

4. Dispositif de filtrage selon la revendication 1 ou 2, comportant une première porte (114) avec un premier noeud de porte (116) qui est relié au premier noeud (106) et avec un deuxième noeud de porte (118) qui est relié à un potentiel de référence (128) et une deuxième porte (120) avec un troisième noeud de porte (122) qui est relié au troisième noeud (110) et avec un quatrième noeud de porte (124) qui est relié au quatrième noeud (112).

5. Dispositif selon l'une des revendications 1 à 4, dans lequel le premier dispositif résonateur (102) comprend un premier élément capacitif (130) et un premier élément de ligne (132) et dans lequel le deuxième dispositif résonateur (104) comprend un deuxième élément capacitif (134) et un deuxième élément de ligne (136).

6. Dispositif de filtrage selon la revendication 5, dans lequel le premier élément capacitif et le deuxième élément capacitif sont formés par un condensateur qui est branché au potentiel de référence, par une ligne capacitive ou par une ligne de dérivation à vide.

7. Dispositif de filtrage selon la revendication 5 ou 6, dans lequel le premier dispositif résonateur (102) comporte un autre élément capacitif (142) qui est branché entre le premier élément de ligne (132) et le deuxième noeud (108) et dans lequel le deuxième dispositif résonateur (104) comporte un autre élément capacitif (144) qui est branché entre le deuxième élément de ligne (136) et le quatrième noeud (112).

8. Dispositif de filtrage selon la revendication 7, dans lequel l'autre élément capacitif (142, 144) est une ligne capacitive.

9. Dispositif de filtrage selon l'une des revendications 1 à 4, dans lequel le premier dispositif résonateur (102) et le deuxième dispositif résonateur (104) comportent chacun au moins un résonateur (152, 154, 156, 158).

10. Dispositif de filtrage selon la revendication 9,
dans lequel l'élément inductif comprend un premier élément inductif (126) qui est branché entre le premier noeud (106) et un cinquième noeud (166) et un deuxième élément inductif (170) qui est branché entre le troisième noeud (110) et le cinquième noeud (166) ;
dans lequel l'autre élément inductif comprend un troisième élément inductif (140) qui est branché entre le deuxième noeud (108) et un sixième noeud (168) et un quatrième élément inductif (172) qui est branché entre le quatrième noeud (112) et le sixième noeud (168) ; et
dans lequel un autre dispositif résonateur (160), qui est couplé au premier dispositif résonateur (102) et au deuxième dispositif résonateur (104), est branché entre le cinquième noeud (166) et le sixième noeud (168).

11. Dispositif de filtrage selon la revendication 10, dans lequel le premier, le deuxième et l'autre dispositif résonateur (102, 104, 106) comprennent chacun plusieurs résonateurs couplés (152, 154, 156, 158, 162, 164).

12. Dispositif de filtrage comportant
un premier dispositif résonateur (202), qui est branché entre un premier noeud (206) et un deuxième noeud (208) ;
un deuxième dispositif résonateur (204), qui est branché entre le deuxième noeud (208) et un troisième noeud (210), le premier dispositif résonateur (202) et le deuxième dispositif résonateur (204) étant couplés d'un point de vue électromagnétique ; et
un élément inductif (226), qui est branché entre le deuxième noeud (208) et un quatrième noeud (212) ;
**caractérisé par**
un troisième dispositif résonateur (280) qui est branché entre un cinquième noeud (284) et le quatrième noeud (212) ; et
un quatrième dispositif résonateur (282) qui est branché entre un sixième noeud (286) et le quatrième noeud (212), le troisième dispositif résonateur (280) et le quatrième dispositif résonateur (282) étant couplés d'un point de vue électromagnétique ;
le premier dispositif résonateur (102) et le deuxième dispositif résonateur (104) comprenant des résonateurs de ligne, des résonateurs BAW, des résonateurs SAW, des résonateurs diélectriques, des résonateurs à quartz et/ou des résonateurs optiques.

13. Dispositif de filtrage selon la revendication 12, dans lequel le premier dispositif résonateur (202) et le deuxième dispositif résonateur (204) dans la bande passante comportent une résonance série et sont couplés.

14. Dispositif de filtrage selon la revendication 12 ou 13, comportant une première porte (214) avec un premier noeud de porte (216) qui est relié au premier noeud (206) et avec un deuxième noeud de porte (218) qui est relié au cinquième noeud (284) et une deuxième porte (220) avec un troisième noeud de porte (222) qui est relié au troisième noeud (210) et avec un quatrième noeud de porte (224) qui est relié au sixième noeud (286).

15. Dispositif de filtrage selon la revendication 12 ou 13, comportant une première porte (214) avec un premier noeud de porte (216) qui est relié au premier noeud (206) et avec un deuxième noeud de porte (218) qui est relié à un potentiel de référence (228) et une deuxième porte (220) avec un troisième noeud de porte (222) qui est relié au troisième noeud (210) et avec un quatrième noeud de porte (224) qui est relié au sixième noeud (286).

16. Dispositif de filtrage selon l'une des revendications 12 à 15, dans lequel chaque dispositif résonateur (202, 204, 280, 282) comprend un élément capacitif (230, 234, 288, 292) et un élément de ligne (232, 236, 290, 294).

17. Dispositif de filtrage selon la revendication 16, dans lequel l'élément capacitif est formé par un condensateur qui est branché en série, par une ligne capacitive ou par une ligne de dérivation à vide.

18. Dispositif de filtrage selon l'une des revendications 12 à 17, dans lequel les dispositifs résonateurs (202, 204, 280, 282) comportent chacun au moins un résonateur.
